# EUROPEAN PATENT APPLICATION

(11) **EP 2 133 450 A1**
(43) Date of publication of application: **16.12.2009**
(21) Application number: 08721552.1
(22) Date of filing: 07.03.2008
(51) Int. Cl.: C30B 29/24, C23C 16/02, C23C 16/34, C30B 25/18, C30B 29/38, H01L 21/205

(54) **SUBSTRATE FOR EPITAXIAL GROWTH AND METHOD FOR PRODUCING NITRIDE COMPOUND SEMICONDUCTOR SINGLE CRYSTAL**

(30) Priority: 14.03.2007 JP 2007065079
(71) Applicant: Nippon Mining & Metals Co., Ltd., Tokyo 105-0001 (JP)
(72) Inventor: TAKAKUSAKI, Misao, Toda-shi Saitama 335-8502 (JP); MORIOKA, Satoru, Toda-shi Saitama 335-8502 (JP); SHIMIZU, Takayuki, Toda-shi Saitama 335-8502 (JP)
(86) International application number: PCT/JP2008/054134
(87) International publication number: WO 2008/126532

(57) **Abstract**

Provided is a technique for stabilizing characteristics of an NdGaO₃ substrate used for epitaxial growth so as to grow a fine nitride compound semiconductor single crystal with good reproducibility. A single crystal of NdGaO₃ grown by a crystal pulling method is subjected to an annealing treatment at 1400°C or more and 1500°C or less for a predetermined time period (for example, 10 hours) in the air, and this annealed NdGaO₃ substrate is used as a substrate for epitaxial growth.

## Description

### Technical Field

The present invention relates to a substrate for growth which is used for epitaxial growth and a method for producing a nitride compound semiconductor single crystal, and particularly relates to a useful technique when an NdGaO₃ substrate is used as the substrate for epitaxial growth.

### Background Art

Conventionally, sapphire, SiC and the like are mainly used for a substrate for epitaxial growth of a nitride compound semiconductor single crystal such as GaN. These substrate materials have a large degree of lattice mismatch with a nitride compound semiconductor such as GaN, and various growth methods were experimented to solve the problem.

For example, in order to solve this lattice mismatch problem, it was proposed to use a rare earth 3B group perovskite substrate whose pseudo lattice constant was close to that of a nitride compound semiconductor, particularly an NdGaO₃ substrate (patent documents 1 to 5). That is, on (011) of the NdGaO₃ substrate, length of a-axis of NdGaO₃ nearly coincides with a lattice constant on <11-20> of GaN. Thus, it is expected this substrate solves the lattice mismatch problem associated with a substrate of sapphire, SiC or the like.

Further, the present inventors proposed a technique which was useful in growing a GaN single crystal on an NdGaO₃ substrate by using hydride vapor phase epitaxy (HVPE) method, and the technique could control film thickness of the GaN single crystal to be uniform and could achieve high quality of the crystal.
Patent document 1: Japanese patent application publication Laid-open No. Hei8-186329
Patent document 2: Japanese patent application publication Laid-open No. Hei8-186078 (Japanese Patent No. 3263891)
Patent document 3: Japanese patent application publication Laid-open No. Hei8-208385 (Japanese patent No. 3564645)
Patent document 4: Japanese patent No. 3293035
Patent document 5: Japanese patent application publication Laid-open No. Hei9-071496 (Japanese patent No. 3692452)

### Disclosure of the Invention

### Problem to be Solved by the Invention

However, even if a GaN single crystal was grown on the NdGaO₃ substrate by the HVPE method, it was not always true that a high-quality GaN single crystal was grown with good reproducibility, and it turned out characteristics of the grown GaN single crystal vary greatly depending on its crystal lot. For example, c-axis orientation was not found at all in some grown GaN single crystals, and there was a problem in orientation. Therefore, in an epitaxyal growth by the HVPE method, it is difficult to improve yield of a GaN single crystal having fine orientation.

It is not preferable to use the GaN single crystals having non-uniform orientation as a substrate and to grow epitaxially a GaN single crystal thick film on this GaN single crystal substrate (GaN thin film template substrate), because the substrate affects to characteristics of the GaN thick film.

It is an object of the present invention to stabilize characteristics of an NdGaO₃ substrate used for epitaxial growth, so as to provide a technique of growing a high-quality nitride compound semiconductor single crystal with good reproducibility.

### Means for Solving the Problem

The invention recited in claim 1 has been made to achieve the above-describe object, and is a substrate for epitaxial growth, obtained from an NdGaO₃ single crystal grown by a crystal pulling method, wherein the substrate is subjected to an annealing treatment at 1400°C or more to 1500°C or less for a predetermined time period (for example, 10 hours) in the air after a crystal pulling step.

The NdGaO₃ single crystal may be subjected to the above-described annealing treatment in an ingot state and then sliced to be the substrate for epitaxial growth, or the NdGaO₃ may be sliced and then subjected to the annealing treatment to be the substrate for epitaxial growth.

The invention recited in claim 2 is a method to grow a nitride compound semiconductor single crystal by the hydride vapor phase epitaxy method, wherein the nitride compound semiconductor single crystal is epitaxially grown by using the NdGaO₃ substrate obtained by the above-described producing method.

Briefly described hereinafter is how the present invention was accomplished.
First, an NdGaO₃ substrate was sliced and polished after crystal growth by a Czochralski method (CZ method) or the like, and then used as a substrate for crystal growth. The present inventors found color of this NdGaO₃ substrate slightly varies depending on its crystal lot and crystal growth manufacturer.

The present inventors thought that the reason why the color of the obtained substrate varied depending on its NdGaO₃ single crystal lot is that an amount of impurities and concentration of oxygen-loss defect were different due to different growth condition (e.g. growth temperature, pulling rate, and the like) of the NdGaO₃ single crystal and annealing condition following the growth. The present inventors further thought that since the characteristics (for example, an amount of impurities and oxygen-loss defect) were not constant but different among NdGaO₃ single crystal lots, a nitride compound semiconductor such as GaN grown on the NdGaO₃ substrate obtained from such single crystals was greatly affected in its orientation.

Thus, the present inventors focused on the annealing condition after an NdGaO₃ single crystal was grown, and got an idea to control the oxygen-loss defect in the NdGaO₃ single crystal by the annealing condition, so that it became possible to uniform the substrate characteristics and to grow an oriented nitride compound semiconductor by the HVPE method with good reproducibility.

The present inventors repeated experiments based on the above idea, and found that when an NdGaO₃ single crystal was annealed at a high temperature of 1400°C or more, a GaN single crystal grown on a substrate obtained from this crystal showed fine orientation. Further, since the NdGaO₃ substrate had cracks or the like when it was annealed at 1500°C or more, an upper limit of the heat treatment was set to 1500°C.

### Advantage of the Invention

According to the present invention, since an oxygen-loss defect of an NdGaO₃ substrate is controlled to be constant by giving the annealing treatment at a high temperature of 1400°C or more, it is possible to achieve a substrate for growth which is suitable for epitaxially growing a nitride compound semiconductor single crystal such as GaN.

Moreover, since a GaN single crystal epitaxially grown on the above substrate for growth shows high orientation, it is possible to grow a high-quality GaN thick film single crystal by using this GaN single crystal as a thin film template substrate.

### Brief Description of Drawings

Fig. 1 is a schematic constitutional view showing a structure of a vapor phase epitaxy apparatus (HVPE apparatus) of the present embodiment.
Fig. 2 is an explanatory view showing a relation between XRD full-width half-maximum and annealing temperature of GaN single crystals grown on respective NdGaO₃ substrates annealed at various temperatures.

### Explanation of Reference Numerals

- 1: reaction furnace
- 2: resistance heater
- 3: gas discharge pipe
- 4: substrate holder
- 5: supply nozzle
- 6: group V material gas supply pipe (NH₃ gas supply pipe)
- 7: HCl gas supply pipe
- 8: N₂ gas supply pipe
- 9: metal material (Ga metal)
- 10: material mounting section
- 11: substrate
- 100: vapor phase epitaxy apparatus (HVPE apparatus)

### Best Mode for Carrying Out the Invention

Hereinafter, a preferable embodiment of the present invention is explained with reference to the drawings.

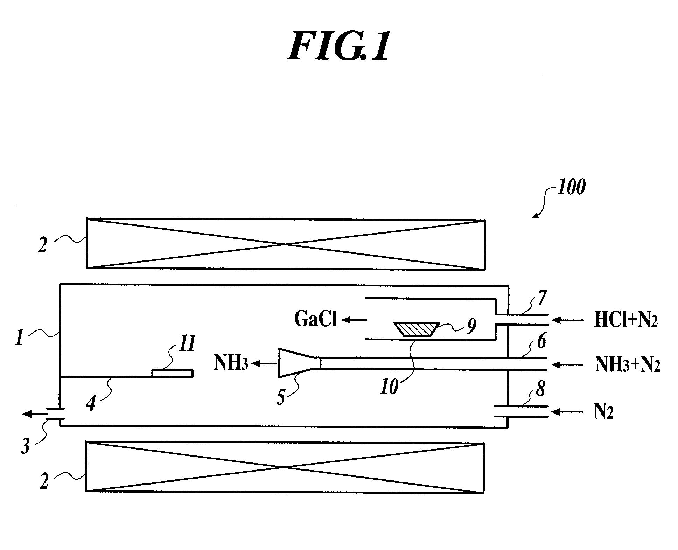

Fig. 1 is a schematic constitutional view showing a structure of a vapor phase epitaxy apparatus (HVPE apparatus) of the present embodiment.

An HVPE apparatus 100 includes a hermetically-sealed reaction furnace 1 and a resistance heater 2 provided around the reaction furnace 1. The reaction furnace 1 is provided with an HCl gas supply pipe 7 which supplies HCl gas to produce a group III material gas, a group V material gas supply pipe 6 to supply group V gas such as NH₃ gas into the reaction furnace, an N₂ gas supply pipe 8 to supply N₂ gas into the reaction furnace, a gas discharge pipe 3 and a substrate holder 4 to mount a substrate 11.

A material mounting section 10 is provided to the HCl gas supply pipe 7, and a metal material 9 to produce group III material gas is placed there. A supply nozzle 5 is provided on a tip of the group V material gas supply pipe 6, and the NH₃ gas is brown to the substrate 11 through this supply nozzle 5. The supply nozzle 5 is provided such that its tip is closer to the substrate than a supply opening of the material mounting section 10. For example, the tip of the supply nozzle 5 is apart from the substrate by 0.7 to 4.0 times as long as a diameter of the substrate.

Next, specifically explained is a case that a GaN single crystal is grown on (011) of an NdGaO₃ substrate where the lattice constant is close to GaN. The NdGaO₃ substrate is as large as 2-inch diameter and 350 µm thickness. The present embodiment shows the case that the GaN single crystal is epitaxially grown by the HVPE method on the NdGaO₃ substrate which has been subjected to a predetermined annealing treatment.

First, an NdGaO₃ single crystal was grown by the CZ method, and then subjected to an annealing treatment in the air in a sliced state to control a defect due to oxygen loss. Specifically, a plurality of NdGaO₃ substrates were subjected to the annealing treatment for 10 hours at annealing temperatures of 1300°C to 1500°C. The color of the NdGaO₃ substrates became approximately same after the annealing treatment.

Next, a GaN thin film single crystal was grown each on the above-described annealed NdGaO₃ substrates by the HVPE method with the HVPE apparatus 100 shown in Fig. 1. The group III material gas was GaCl produced from Ga metal and HCl, and the group V material gas was NH₃.

The above-described annealed NdGaO₃ substrates were mirror-polished and their surfaces were further treated by the following procedure according to need. Specifically, they were cleaned by ultrasonic in acetone and then in methanol each for 5 minutes, thereafter blown with nitrogen gas to blow out droplets and dried naturally, and further etched with a sulfuric acid etchant (for example, phosphoric acid : sulfuric acid = 1:3 (volume ratio), 80°C) for 5 minutes.

Next, these NdGaO₃ substrates 11 were each mounted on a predetermined position of the substrate holder 4 and cleaned by raising the substrate temperature to 800°C, and then the substrate temperature was lowered to 600°C of a GaN growing temperature while N₂ gas was introduced from the N₂ gas supply pipe 8. Thereafter, HCl gas was introduced from the HCl gas supply pipe 6 to let the HCl react with the Ga metal 9 to produce GaCl, and this GaCl was supplied onto the NdGaO₃ substrate 11. Also, NH₃ gas was introduced onto the NdGaO₃ substrate 11 from the NH₃ gas supply pipe 7 through the supply nozzle 5. Here, N₂ gas was used as carrier gas.

Then, the single crystals were grown for 5 minutes at a growth rate of about 0.72 µm/h while introducing rates of respective gases were controlled so that GaCl partial pressure was 0.002 atm and NH₃ partial pressure was 0.066 atm, and thus the GaN single crystals of 50 to 70 nm were obtained.

The GaN single crystals obtained by the above-described method were each subjected to X-ray diffraction to measure a rocking curve of GaN(0002) reflection, and the full-width half-maximum thereof (XRD full-width half-maximum) was obtained to check orientation of the GaN single crystals.

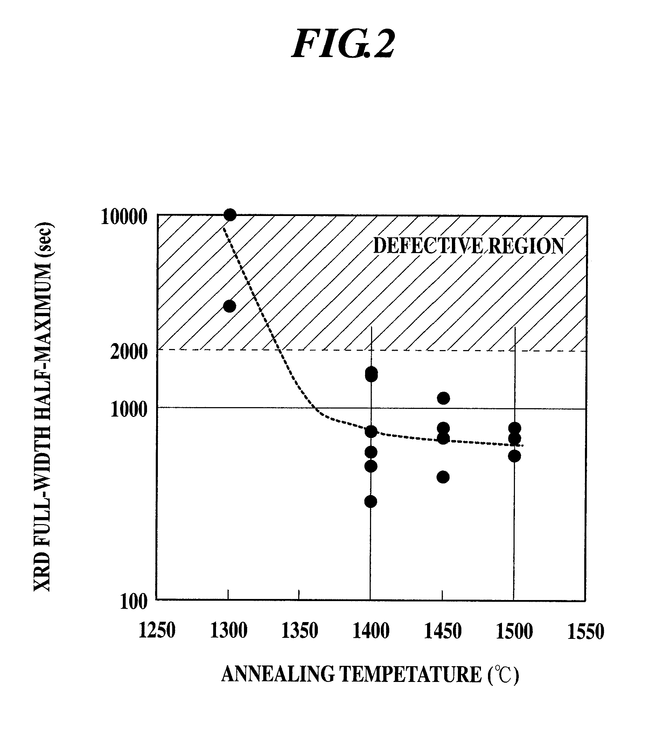

Fig. 2 is an explanatory view showing a relation between XRD full-width half-maximum and annealing temperature of the GaN single crystals grown on respective NdGaO₃ substrates annealed at various temperatures.

When the GaN thin film single crystal grown on the NdGaO₃ substrate is used as a substrate and a GaN thick film is further epitaxially grown thereon, it is required that the XRD full-width half-maximum of the GaN thin film single crystal is 2000 seconds or less. This is because if the XRD full-width half-maximum is over 2000 seconds, it becomes difficult to grow epitaxially the GaN thick film single crystal layer having fine characteristics on the GaN thin film single crystal substrate.

Thus, quality of orientation was judged based on the XRD full-width half-maximum of the obtained GaN single crystal with its reference at 2000 seconds, so as to judge which annealed NdGaO₃ substrate is suitable for epitaxial growth.

According to Fig. 2, while the XRD full-width half-maximums of the GaN single crystals grown on the NdGaO₃ substrates annealed at 1300°C were 2000 seconds or more, the XRD full-width half-maximums of the GaN single crystals grown on the NdGaO₃ substrates annealed at 1400°C to 1500°C were stably less than 2000 seconds.

Therefore, it can be said the NdGaO₃ substrates annealed at the temperatures of 1400°C or more are suitable for epitaxial growth. By growing the GaN single crystal on said substrates, it becomes possible to improve orientation of a GaN single crystal and keep the XRD full-width half-maximum 2000 seconds or less with good reproducibility. The upper limit of the annealing temperature was set to 1500°C because the NdGaO₃ substrates had cracks or the like at the temperature of 1500°C or more.

Further, the GaN thin film single crystal epitaxially grown on the NdGaO₃ substrate annealed at 1400°C to 1500°C was used as a substrate, and the GaN thick film single crystal was further epitaxially grown thereon. As a result, it was confirmed the GaN thick film single crystal having fine characteristics could be obtained.

In the foregoing, the invention made by the present inventors is specifically explained based on the embodiment. However, the present invention is not limited to the above embodiment.

For example, in the above embodiment, after the NdGaO₃ single crystal is grown by the CZ method, the annealing treatment is given to that of a sliced state. However, the same advantage is achieved even if the NdGaO₃ single crystal is subjected to the annealing treatment in an ingot state.

The present invention is not limited to growth of a GaN single crystal, and can be also applied to growth of nitride compound semiconductor single crystals using the HVPE method.

The substrate for growth is not limited to the NdGaO₃ substrate, and there is a possibility that rare earth group 13 (3B) perovskite crystals, such as NdAlO₃, NdInO₃ and the like for example, are applicable as the substrate.

In the above embodiment, a horizontal HVPE apparatus is explained. However, a vertical HVPE apparatus can also achieve the same advantage by supplying the group III material gas (for example, GaCl) through a nozzle.

## Claims

1. A substrate for epitaxial growth, obtained from an NdGaO₃ single crystal grown by a crystal pulling method, wherein
the substrate is subjected to an annealing treatment at 1400°C or more to 1500°C or less for a predetermined time period in the air after a crystal pulling step.

2. A method for producing a nitride compound semiconductor single crystal, wherein
the nitride compound semiconductor single crystal is epitaxially grown by using the substrate of NdGaO₃ according to claim 1 in a hydride vapor phase epitaxy method.
